# EUROPÄISCHE PATENTANMELDUNG

(11) **EP 2 221 275 A2**
(43) Veröffentlichungstag der Anmeldung: **25.08.2010**
(21) Anmeldenummer: 10153652.2
(22) Anmeldetag: 16.02.2010
(51) Int. Cl.: C01B 35/02, C01B 35/04, H01R 39/14

(54) **Verfahren zur Herstellung von hochreinem, amorphen Bor, insbesondere für eine Verwendung bei MgB2 Supraleitern**

(30) Priorität: 20.02.2009 DE 102009009804
(71) Anmelder: Bruker EAS GmbH, 63450 Hanau (DE)
(72) Erfinder: Aubele, André, 63457 Hanau (DE); Sailer, Bernd, 63755 Alzenau (DE)
(74) Vertreter: Schmitt, Martin

(57) **Zusammenfassung**

Die Erfindung betrifft ein Verfahren zur Herstellung von hochreinem, amorphen Bor, wobei ein reduzierendes Gas und ein gasförmiges Borhalogenid in eine Reaktionskammer (10;32) eines Reaktors (8;9;30;42) während dessen Betriebs kontinuierlich oder quasikontinuierlich eingeleitet wird, wobei in der Reaktionskammer (10;32) des Reaktors (8;9;30;42) eine Oberfläche eines Katalysators (15;20;37) zur Verfügung gestellt wird, der die Reaktion des Borhalogenids zu Bor unterstützt, und wobei an der Oberfläche des Katalysators (15;20;37) abgeschiedenes Bor regelmäßig mechanisch abgelöst wird, so dass das abgelöste Bor in Pulverform in der Reaktionskammer (10;32) des Reaktors (8;9;30;42) vorliegt. Mit dem erfindungsgemäßen Verfahren wird hochreines amorphes Bor hergestellt, das ohne eine nachgeschaltete Zerkleinerung des gewonnenen Bors bereits eine sehr geringe Korngröße aufweist. Die Nutzung derartig hergestellten Borpulvers wird insbesondere für die Supraleiterherstellung im System Magnesium-Bor aufgrund der verbesserten Stromtragfähigkeit vorgeschlagen.

## Beschreibung

Die Erfindung betrifft ein Verfahren zur Herstellung von hochreinem, amorphem Bor, wobei ein reduzierendes Gas und ein gasförmiges Borhalogenid in eine Reaktionskammer eines Reaktors während dessen Betriebs kontinuierlich oder quasikontinuierlich eingeleitet wird.

Ein derartiges Verfahren ist aus der US 2008 0056976 A1 bekannt geworden.

Seit der Entdeckung der Supraleitfähigkeit im System Magnesium-Bor sind in der Weiterentwicklung dieses Systems große Anstrengungen unternommen worden. Hierdurch konnten im Vergleich zu anderen Supraleitungssystemen große Fortschritte bezüglich der Leistungsfähigkeit der supraleitenden Materialien erzielt werden. Es hat sich gezeigt, dass die Qualität der Ausgangsstoffe einen großen Einfluss auf die Leistungsfähigkeit eines MgB₂-Supraleiters hat. Dabei ist die Qualität des eingesetzten Bors maßgebend. Nach herrschender Meinung wird möglichst reines amorphes Bor zur Herstellung von Magnesiumdiborid (MgB₂) benötigt. Ein für die Leistungsfähigkeit eines Supraleiters wesentliches Merkmal, die Stromtragfähigkeit, kann insbesondere über die Korngröße des verwendeten Borpulvers beeinflusst werden. Erwünscht sind dabei feinkörnige Pulver mit einer engen Korngrößenverteilung, da mit diesen eine höhere Stromtragfähigkeit im MgB₂-Material erzielt wird als mit grobkörnigen Pulvern.

Aus dem Stand der Technik sind verschiedene Verfahren zu Herstellung von Bor bekannt. Bor wird zum Beispiel auf aluminothermischem Wege gewonnen. Die Aluminothermie ist ein in der Technik häufig angewandtes Verfahren, bei dem metallische Elemente (in diesem Fall Bor) aus den entsprechenden Metalloxiden durch die Umsetzung mit elementarem Aluminium oder anderen unedlen metallischen Reduktionsmitteln (z. B. Mg, oder Alkalimetalle) gewonnen werden. Dabei lassen sich nur relativ geringe Reinheiten des gewonnenen Bors erzielen (bis ca. 95%), sodass anschließend aufwändige Reinigungsverfahren, wie z.B. aufeinander folgende Waschstufen, erforderlich sind, um höhere Reinheitswerte zu erhalten. Die Reinigungsverfahren verteuern jedoch deutlich das an sich relativ günstige aluminothermische Herstellungsverfahren. Die geringe Reinheit des durch die Aluminothermie gewonnenen Bors resultiert zu einem wesentlichen Anteil aus Sauerstoffverunreinigungen, die sich durch die Anwesenheit der Metalloxide bei der aluminothermischen Reaktion ergeben. Diese Sauerstoffverunreinigungen können, falls sie nicht beseitigt werden, im späteren Magnesiumdiborid-Supraleiter in nachteiliger Weise isolierend wirken.

Darüber hinaus ist zur Herstellung von Borfasern ein weiteres Borgewinnungsverfahren bekannt, bei dem Borhalogenide durch die Einspritzung in ein Plasma zu Borfasern reduziert werden. Derartige Borfasern werden bei Faserverbundwerkstoffen aufgrund ihrer hohen Belastbarkeit bevorzugt eingesetzt. Dieses Verfahren ergibt, verglichen mit dem aluminothermischen Herstellungsverfahren, höhere Reinheitswerte des gewonnenen Bors, ist jedoch auch vergleichsweise teuer. Zudem wird auch dieses Verfahren zum Teil von Sauerstoffverunreinigungen begleitet.

Des Weiteren ist zur Gewinnung verschiedener Bormodifikationen die Reaktion von Borhalogeniden an Metalloberflächen unter Anwesenheit von Wasserstoff bekannt, wobei eine Bormodifikation und der jeweilige Halogenwasserstoff entstehen (http://www.seilnacht.com/Lexikon/05Bor.htm). Hierbei lassen sich im Vergleich zu aluminothermischen Herstellungsverfahren ebenfalls höhere Reinheiten des gewonnenen Bors erzielen. Allerdings ist hierbei keine kontinuierliche Reaktionsführung bekannt, die eine Borgewinnung in größeren Mengen erlauben würde. Zudem ist eine kontrollierte Einflussnahme auf die resultierende Teilchengröße des Bors kaum möglich.

In der oben genannten US 2008 0056976 A1 wird zur Herstellung eines supraleitfähigen MgB₂-Drahtes durch eine Reaktion von gasförmigem BCl₃ und H₂ dotiertes Bor als Beschichtung auf ein faserartiges Substrat aus Siliziumcarbid aufgebracht. Die auf diese Weise mit Bor beschichtete Faser wird im Anschluss einem Magnesiumdampf ausgesetzt, um dotiertes Magnesiumdiborid (MgB₂) als Supraleiter zu erhalten. Bei diesem Verfahren sind jedoch ausschließlich Drähte mit einem Siliziumcarbid-Kern herstellbar. Es kann insbesondere kein Borpulver gewonnen werden.

### Aufgabe der Erfindung

Es ist die Aufgabe der vorliegenden Erfindung, ein wirtschaftliches Verfahren zur Herstellung größerer Mengen an hochreinem, amorphen Bor zur Verfügung zu stellen, bei dem eine gute Kontrolle über die resultierende Teilchengröße des Bors gegeben ist, und das insbesondere zur Gewinnung von feinkörnigem Borpulver für die Herstellung von MgB₂-Supraleitermaterial geeignet ist.

### Kurze Beschreibung der Erfindung

Diese Aufgabe wird gelöst durch ein Verfahren der eingangs genannten Art, das dadurch gekennzeichnet ist, dass
a) in der Reaktionskammer des Reaktors eine Oberfläche eines Katalysators zur Verfügung gestellt wird, der die Reaktion des Borhalogenids zu Bor unterstützt, und
b) an d er Oberfläche des Katalysators abgeschiedenes Bor regelmäßig mechanisch abgelöst wird, so dass das abgelöste Bor in Pulverform in der Reaktionskammer des Reaktors vorliegt.

Mit dem erfindungsgemäßen Verfahren wird hochreines amorphes Bor hergestellt, das ohne eine zusätzliche Weiterbehandlung bereits sehr kleine Korngrößen aufweist. Das derartig hergestellte Borpulver kann insbesondere für die Herstellung von MgB₂ - Supraleitermaterial mit einer hohen Stromtragfähigkeit eingesetzt werden.

Zur erfindungsgemäßen Borpulvergewinnung wird das gasförmige Borhalogenid und das reduzierende Gas (in der Regel Wasserstoff) in die Reaktionskammer eingeleitet. In Anwesenheit des Katalysators, der z.B. aus Wolfram oder Tantal bestehen kann, reagieren die eingeleiteten Gase zu Bor und einem flüchtigen weiteren Reaktionsprodukt (typischerweise der jeweilige Halogenwasserstoff). Dabei wird das Bor zunächst an der Oberfläche des Katalysators abgeschieden. Nachdem eine gewisse Menge an Bor am Katalysator abgeschieden wurde, wird das Bor vom Katalysator abgelöst. Das Ablösen des Bors von der Katalysatoroberfläche erfolgt erfindungsgemäß durch regelmäßige mechanische Vorgänge, sodass ein feinkörniges hochreines Borpulver erhalten werden kann. Als mechanische Vorgänge können erfindungsgemäß z.B. Rütteln, Kratzen, Schaben, oder auch strömungsmechanische Vorgänge, wie beispielsweise die Druckwellen eines Gases, genutzt werden. Bevorzugt erfolgen die regelmäßigen (sich wiederholenden) Vorgänge periodisch, sodass mit jedem Abtrag ähnlich große Borpartikel erhalten werden.

Ein wesentlicher Vorteil der Erfindung ist somit, dass das erfindungsgemäße Verfahren die Borgewinnung in einem kontinuierlichen oder quasikontinuierlichen Prozess erlaubt und somit auch für größere Bormengen gut geeignet ist.

Als reduzierendes Gas wird typischerweise gasförmiger Wasserstoff und als gasförmiges Borhalogenid in der Regel Bortrichlorid (BCl₃) verwendet. Die Einleitung dieser oder anderer Stoffe (Edukte) in die Reaktionskammer erfolgt kontinuierlich oder quasikontinuierlich. Quasikontinuierliche Vorgänge sind z.B. Vorgänge, die gleichartig und gleichmäßig fortlaufen, jedoch von Schüben (z.B. Pulsen) oder auch kurzzeitigen Unterbrechungen geprägt sein können. Während der kontinuierlichen oder quasikontinuierlichen Einleitung der Edukte schreitet die Borabscheidung am Katalysator voran.

Ein wesentlicher Vorteil der Erfindung ist, dass sehr kleine Teilchengrößen beim entstehenden Borpulver erzielbar sind, wobei das Borpulver gleichzeitig eine sehr hohe Reinheit aufweist. Somit kann insgesamt eine verbesserte Stromtragfähigkeit eines Supraleiters aus Magnesiumdiborid erreicht werden. Die Teilchengröße des abgeschiedenen Bors lässt sich einerseits über die Frequenz beeinflussen, mit der das Bor mechanisch von der Katalysatoroberfläche abgetragen wird, und andererseits über die Geschwindigkeit, mit der das Bor an der Katalysatoroberfläche abgeschieden wird. Diese Geschwindigkeit ist z.B. über die Wahl des Katalysatormaterials (Tantal, Wolfram, etc.) oder andere Einflussgrößen, wie die Reaktionstemperatur, einstellbar.

Ein weiterer Vorteil der Erfindung liegt in der Nutzung rein gasförmiger Ausgangsstoffe für die Reaktion zu Borpulver. Diese sind kommerziell in hoher Reinheit erhältlich.

Ebenfalls von Vorteil ist, dass bei dem erfindungsgemäßen Verfahren neben dem Borpulver nur ein gasförmiges Nebenprodukt, in der Regel ein Halogenwasserstoff, entsteht. Dadurch entfallen aufwändige Reinigungsverfahren, wie z.B. die Waschvorgänge, die sich an die bekannten aluminothermischen Borgewinnungsverfahren anschließen. Da beim erfindungsgemäßen Verfahren gasförmiger Halogenwasserstoff entsteht und das Bor als Feststoff "ausfällt", sind die Reaktionsprodukte in einfacher Art und Weise voneinander trennbar. Unter Ausnutzung der Gravitation kann das Borpulver beispielsweise durch ein sumpfartiges Reservoir im unteren Bereich der Reaktionskammer aufgefangen werden, wohingegen das gasförmige Reaktionsprodukt über einen entsprechenden Auslass an der Reaktionskammer abgeführt wird.

In vorteilhafter Weise wird neben der Gewinnung von feinstem Borpulver durch das erfindungsgemäße Verfahren auch gleichzeitig eine sehr hohe Reinheit des Bors erzielt. Dies ist insbesondere dadurch bedingt, dass kein Sauerstoff an der Reaktion von beispielsweise Wasserstoff und Bortrichlorid zu Bor und Chlorwasserstoff beteiligt ist. Durch die kontrollierte Abwesenheit von Sauerstoff während der Reaktion können unerwünschte Sauerstoffverunreinigungen vermieden werden.

Schließlich ist bei einem Supraleiter, der aus erfindungsgemäß hergestelltem Borpulver hergestellt wird, die aufgrund der hohen Reinheit und kleinen Korngröße des Borpulvers verbesserte Stromtragfähigkeit ein wesentlicher Vorteil für die Leistungsfähigkeit des Supraleiters.

### Bevorzugte Varianten der Erfindung

Bevorzugt ist eine Variante des erfindungsgemäßen Verfahrens, bei der die mechanische Ablösung des abgeschiedenen Bors während des Betriebs des Reaktors erfolgt. Den Betrieb des Reaktors kennzeichnet erfindungsgemäß die über einen größeren Zeitraum (z.B. 5 Minuten oder länger) fortwährende Zurverfügungstellung der Reaktionsedukte in der Reaktionskammer. Gemäß dieser Verfahrensvariante kann somit unmittelbar nach einer erfolgten Ablösung bzw. Abtragung von Borpulver vom Katalysator eine weitere Boranreicherung am Katalysator erfolgen, wobei die weitere Boranreicherung dann wiederum in einem nächsten Abtragungszyklus abgestreift wird. Der Reaktor muss dann nicht für die in der Regel nur geringe Borpulvermenge einer einzigen Boranreicherung am Katalysator in Betrieb genommen werden und anschließend abgeschaltet werden, sondern es können durch die Vornahme mehrerer Borabtragungen während des Reaktorbetriebs, in vorteilhafter Weise größere Mengen an Borpulver produziert werden.

Bevorzugt ist auch eine Variante des erfindungsgemäßen Verfahrens, bei der zur mechanischen Ablösung des abgeschiedenen Bors von der Oberfläche des Katalysators der Katalysator in Schwingung versetzt wird. Bei einer beispielsweise periodisch erzwungenen Schwingung des Katalysators im Reaktionsraum führt die damit einhergehende wechselweise erfolgende Beschleunigung und Verzögerung der Katalysatoroberfläche zu einer regelmäßigen und einfach zu bewirkenden Ablösung des gebildeten Borpulvers. Die Haftkräfte, über die das Bor am Katalysator haftet, werden überwunden. Ein derartiger schwingungsfähiger Katalysator kann z.B. als festes Tantal- oder Wolframstück ausgebildet sein, das im Reaktionsraum schwingfähig gelagert ist und von außerhalb der Reaktionskammer zu periodischen Schwingungen angeregt wird.

Besonders bevorzugt ist weiterhin eine Variante des erfindungsgemäßen Verfahrens, die dadurch gekennzeichnet ist, dass zur mechanischen Ablösung des abgeschiedenen Bors von der Oberfläche des Katalysators eine Druckgaswelle über die Oberfläche des Katalysators geleitet wird. Somit ist keine aufwändige Motorik erforderlich, um die mechanische Ablösung des Borpulvers vom Katalysator zu erreichen. Die Haftung des Bors am Katalysator wird stattdessen mit Hilfe des strömungsmechanischen Vorgangs der pulsierenden Druckgaswelle überwunden. Darüber hinaus hat diese Verfahrensvariante den vorteilhaften Nebeneffekt, dass durch sie das Gas in der Reaktionskammer stark verwirbelt. Hierdurch werden die an der chemischen Reaktion beteiligten Borhalogenide und auch das reduzierende Gas feinst in der Reaktionskammer verteilt. Dies fördert eine effektive und homogene Reaktion zu feinteiligem Bor.

Eine ebenfalls bevorzugte Verfahrensvariante sieht vor, dass zur mechanischen Ablösung des abgeschiedenen Bors von der Oberfläche des Katalysators die Oberfläche des Katalysators abgestreift wird. Ein Abstreifen des Katalysators zur Borabtragung lässt sich in einfacher Art und Weise durch konstruktive mechanische Lösungen realisieren. Zum Beispiel können miteinander teilweise in Anlage stehende Scheiben aus katalytischem Material, durch rotierende Bewegungen aneinander reiben und somit das an der jeweils freien Katalysatoroberfläche anfallende Borpulver abstreifen. Ebenfalls denkbar sind Abstreifvorrichtungen, die entlang von geschlossenen Rohrkreisläufen aus katalytischem Material geführt sind, wobei sie besenartig das anfallende Bor von der Rohroberfläche abkehren.

Eine andere Verfahrensvariante sieht vor, dass als reduzierendes Gas Wasserstoffgas eingesetzt wird. Mit Wasserstoffgas wird ein chemisches Element genutzt, das bei zahllosen chemischen Anwendungen in der Industrie und Technik verwendet wird und somit in der Regel leicht beschaffbar ist. Alternativ kommen beispielsweise auch gesättigte Kohlenwasserstoffe wie Methan oder auch Ammoniak in Frage; dadurch können ggf. gezielt Dotierungen, etwa mit C oder N, in das Bor eingebracht werden.

Bevorzugt ist des Weiteren eine Verfahrensvariante, bei der als Borhalogenid BCl₃ oder BBr₃ eingesetzt wird. Bortrichlorid (BCl₃) ist kommerziell in vorteilhafter Weise in hoher Reinheit erhältlich. Auch das weniger gängige Bortribromid (BBr₃) eignet sich gut zur Gewinnung von pulverförmigem amorphem Bor.

Bei einer besonders bevorzugten Verfahrensvariante wird die Reaktion zwischen dem reduzierenden Gas und dem Borhalogenid bei einer Temperatur zwischen 700°C und 1100°C, und bevorzugt zwischen 800 °C und 1000 °C, geführt. In diesem Temperaturbereich ist die Umsetzung zu amorphem Bor besonderes effizient. Kristalline Boranteile sind minimiert. Kristallines Bor ist schwerer zu Magnesiumdiborid umzusetzen und führt in der Regel zu Einschlüssen im Supraleitermaterial, die leistungsmindernd wirken. Die Reaktionstemperatur kann über Heizelemente eingestellt werden, die z.B. an der Reaktionskammerwand angebracht sind.

In den Rahmen der Erfindung fällt auch die Verwendung eines Reaktors in dem oben beschriebenen, erfindungsgemäßen Verfahren, wobei der Katalysator an mindestens einer Innenwand der Reaktionskammer des Reaktors angeordnet ist, und wobei zur mechanischen Ablösung des abgeschiedenen Bors von der Oberfläche des Katalysators ein mechanischer Aktuator vorgesehen ist, mit dem die Reaktionskammer des Reaktors in Schwingung versetzt werden kann. Die Reaktionskammer kann nach dieser Verwendung als ganzes in Schwingung versetzt werden, ohne dass dabei der mechanische Aktuator in den Innenraum der Reaktionskammer hineinragen müsste (was typischerweise aufwändige Abdichtungsmaßnahmen erfordern würde). Der Aufbau der Reaktionskammer ist dann besonderes einfach. Typischerweise ist die Innenwand (bzw. sind die Innenwände), an der der Katalysator angeordnet ist, beheizt, insbesondere elektrisch beheizt, wodurch sich die Temperatur in der Reaktionskammer, insbesondere am Katalysator, direkt und einfach beeinflussen lässt.

Ebenfalls in den Rahmen der vorliegenden Erfindung fällt die Verwendung eines Reaktors nach einer der vorgenannten Varianten des erfindungsgemäßen Verfahrens, wobei der Katalysator im Innenraum der Reaktionskammer des Reaktors angeordnet ist, und wobei zur mechanischen Ablösung des abgeschiedenen Bors von der Oberfläche des Katalysators ein mechanischer Aktuator vorgesehen ist, mit dem der Katalysator im Innenraum der Reaktionskammer des Reaktors in Schwingung versetzt werden kann. Damit muss in vorteilhafter Weise nicht die gesamte Reaktionskammer in Schwingung versetzt werden. Stattdessen kann eine Beschränkung der Schwingungsbewegung auf die an der Borpulverbildung wesentlich beteiligten Katalysatoren erfolgen; dies ist insbesondere bei vergleichsweise großen Reaktionskammern von Vorteil. Durch die Anordnung des Katalysators im Innenraum der Reaktionskammer kann die Reaktion darüber hinaus in einem Bereich der Reaktionskammer erfolgen, der in der Regel gut durchmischt ist. Es kommt somit zu einer effektiven und homogenen Reaktion, die sich in einer hohen Reinheit des Borpulvers äußert. Typischerweise ist der Katalysator beheizt, insbesondere wobei der Katalysator elektrisch beheizt ist. Somit lässt sich die Reaktionstemperatur leicht einstellen.

In den Rahmen der Erfindung fällt auch die Verwendung eines Reaktors nach einer der vorgenannten Varianten des erfindungsgemäßen Verfahrens, wobei der Reaktor eine Pulsationskammer und die Reaktionskammer aufweist, wobei die Pulsationskammer und die Reaktionskammer über eine gemeinsame Öffnung miteinander verbunden sind, wobei der Strömungsquerschnitt der Pulsationskammer größer ist als der Strömungsquerschnitt der Reaktionskammer, wobei die Pulsationskammer über ein Klappensystem mit einem Brenngas und einem Oxidationsgas befüllt wird, wobei das Brenngas und das Oxidationsgas in der Pulsationskammer ein explosives Gasgemisch bilden, das regelmäßig zur Explosion gebracht wird, und wobei sich das Klappensystem automatisch bei einem von der Explosion herrührenden Druckanstieg in der Pulsationskammer schließt.

Die Pulsationskammer und die Reaktionskammer werden für den Fall, dass die Pulsationskammer außer der gemeinsamen Öffnung keine weiteren Ablassöffnungen aufweist, von einem Gasstrom räumlich und zeitlich nacheinander durchströmt. Dieser Gasstrom besteht in der Regel aus den Edukten und Produkten des explosiven Gasgemischs und den Edukten und Produkten der Borpulverbildung, wobei eine Zuführung der Edukte der Borpulverbildung auch erst in der Reaktionskammer erfolgen kann. Der Gasstrom wird durch die pulsierende Verbrennung des explosiven Gasgemisches in der Pulsationskammer quasikontinuierlich "angetrieben" bzw. schubweise fortbewegt und somit durch die Reaktionskammer geschoben. In der Reaktionskammer findet die Borpulverbildung am Katalysator statt. Hierbei wird der pulsierende Vorschub des Gasstroms nicht nur zur Bereitstellung der Borpulverreaktionsedukte in der Reaktionskammer genutzt, sondern gleichzeitig zur regelmäßigen strömungsmechanischen Abtragung des entstandenen Bors vom Katalysator. Abhängig vom eingesetzten Expolsivgasgemisch kommen unterschiedliche Zündmechanismen in Frage. So kann im Falle eines Wasserstoff-Sauerstoffgemisches die Zündung beispielsweise durch einen elektrisch erzeugten Zündfunken erfolgen. Im günstigsten Fall ensteht hier sogar eine sich selbst erhaltende pulsierende Verbrennung. Im Falle eines Wasserstoff-Chlorgasgemisches kann die Zündung auch durch UV-Licht erfolgen.

Besonders vorteilhaft ist bei dieser Verwendung die gute Durchmischung der Edukte in der Reaktionskammer, die zu einer effektiven und homogenen Reaktion zu feinteiligem amorphem Bor führt. Durch die unterschiedlichen Strömungsquerschnitte der beiden Kammern wird eine Verstärkung des Druckgaswelleneffekts in der Reaktionskammer erzielt, sodass es in vorteilhafter Weise auch bei geringen Mengen des explosiven Gasgemisches zu einem mechanischen Abtrag bzw. Abstreifen des Borpulvers am Katalysator kommt. Das Klappensystem, das z.B. aus einfachen Rückschlagventilen für das Brenn- und Oxidationsgas ausgebildet sein kann, sichert einerseits das quasikontinuierliche Zuströmen des Brenn- und Oxidationsgases in die Pulsationskammer, andererseits sichert es kurz nach dem Zünden des explosiven Gasgemischs das Schließen der Rückschlagventile und somit eine kurzzeitige Unterbrechung der Zufuhr der Edukte des explosiven Gasgemischs. Somit sichert das Klappensystem insgesamt eine kontrollierte, pulsierende, quasikontinuierliche Verbrennung.

Eine Variante der vorgenannten Verwendung ist **dadurch gekennzeichnet, dass** die Pulsationskammer einen Ablass, insbesondere ein Resonanzrohr, zur Entlastung des Explosionsdrucks aufweist. Dies beugt der Gefahr vor, dass Anteile des Oxidationsgases, die während der Explosion des explosiven Gasgemischs möglicherweise nicht vollständig reagiert haben, in die Reaktionskammer verschleppt werden und dort z.B. zu unerwünschten Sauerstoffverunreinigungen führen. Der Ablass oder das Resonanzrohr ist unmittelbar an die Pulsationskammer angeschlossen. Dadurch wird der Großteil der Druckwelle über das Resonanzrohr abgegeben. Ein geringerer Teil der Druckwelle wird an die Reaktionskammer weitergegeben, wo durch die Druckwelle weiterhin der mechanische Abtrag des Borpulvers vom Katalysator erfolgt. Durch die verminderte Druckwellenwirkung wird die oben genannte Vorbeugung gegen eine Oxidationsgas-Verschleppung in die Reaktionskammer erreicht.

Die Pulsationskammer mit angeschlossenem Ablass und die Reaktionskammer können anstelle einer gemeinsamen, verbindenden Öffnung auch eine gemeinsame, zumindest weitgehend gasundurchlässige elastische Membran (etwa ein engmaschiges Metalldrahtgeflecht aus einem inerten Material) oder einen gemeinsamen, in beide Kammern hinein verfahrenden Kolben aufweisen. Diese Membran bzw. der bewegliche Kolben ist einerseits mit dem Innenraum der Pulsationskammer und andererseits mit dem Innenraum der Reaktionskammer verbunden. Mit anderen Worten: Eine derartige Membran bzw. Kolben stellt eine Art Bindeglied zwischen der Pulsationskammer und der Reaktionskammer dar, wobei die jeweiligen Innenräume voneinander abgegrenzt bleiben. Bei der Nutzung eines derartigen Reaktors werden das Oxidations- und das Brenngas direkt in die Pulsationskammer und das reduzierende Gas und das Borhalogenid direkt in die Reaktionskammer eingeleitet. Das wiederholte Zünden des explosiven Gasgemischs in der Pulsationskammer bewirkt jeweils eine kurzzeitige stoßartige Auswölbung der Membran bzw. eine Auslenkung des Kolbens in die Reaktionskammer hinein, wodurch wiederholte Druckgaswellen durch die Reaktionskammer in Gang gesetzt werden, die das am Katalysator angereicherte Bor regelmäßig mechanisch abtragen. Durch das Vorhandensein eines Ablasses (z.B. eines Resonanzrohrs) der Pulsationskammer wird sichergestellt, dass die elastische Membran nicht durch einen zu starken Druckanstieg in der Pulsationskammer zerstört wird. Durch eine derartige Ausgestaltung des Reaktors wird sichergestellt, dass keinerlei Oxidationsgas, insbesondere kein Sauerstoff, in die Reaktionskammer eintreten kann. Damit ist eine saubere Borgewinnung sichergestellt.

Bei einer Variante der beiden vorhergehenden Verwendungen wird in der Pulsationskammer als Brenngas im explosiven Gasgemisch das gleiche Gas eingesetzt wie in der Reaktionskammer als reduzierendes Gas. Dies reduziert die Komplexität des Verfahrens in vorteilhafter Weise, denn es sind dann nur wenige unterschiedliche Stoffe an der Produktion des amorphen Bors beteiligt. Eine andere Variante der vorgenannten Verwendungen sieht vor, dass im explosiven Gasgemisch das Brenngas im Vergleich zum Oxidationsgas im Überschuss eingesetzt wird. Dabei ist ein typisches Brenngas Wasserstoff und ein typisches Oxidationsgas Sauerstoff oder Luft oder ein Luftgemisch. Der Vorteil eines Brenngasüberschusses liegt darin, dass dieser Überschuss für einen vollständigen Verbrauch des Oxidationsgases sorgt und somit ein Eindringen von Oxidationsgas in die Reaktionskammer verhindert. Wird in der Pulsationskammer als Brenngas im explosiven Gasgemisch das gleiche Gas eingesetzt wie in der Reaktionskammer als reduzierendes Gas, so ist es darüber hinaus möglich, auf eine separate Einleitung des reduzierenden Gases in die Reaktionskammer zu verzichten. Denn das Brenngas, das im Überschuss in die Pulsationskammer eingeleitet wurde und das nach der erfolgten Explosion nicht reagiert hat, kann, nachdem es über die gemeinsame Öffnung in die Reaktionskammer gelangt ist, bei der Borpulverbildung als reduzierendes Gas eingesetzt werden. Als weitere Kombination aus Brenn- und Oxidationsgas ist auch Wasserstoff und Chlor möglich.

Eine weitere Variante der vorgenannten Verwendungen ist **dadurch gekennzeichnet, dass** das Borhalogenid direkt, insbesondere kontinuierlich, in die Reaktionskammer eingeleitet wird. Somit ist ein effektiverer Betrieb des Reaktors möglich. Denn das Borhalogenid gelangt bei dieser Variante der Verwendung nicht über die Pulsationskammer und die gemeinsame Öffnung in die Reaktionskammer, wobei wertvolles Borhalogenid z.B. über das Resonanzrohr ungenutzt verloren gehen könnte. Vielmehr wird das Borhalogenid an der Stelle eingesetzt, an der die gewünschte Borpulverreaktion stattfindet, also direkt in der Reaktionskammer.

Bei einer anderen Variante der vorgenannten Verwendungen wird das reduzierende Gas direkt, insbesondere kontinuierlich, in die Reaktionskammer eingeleitet. Es ist damit eine genauere Kontrolle des reduzierenden Gases möglich. Das reduzierende Gas wird somit nicht nur über die Pulsationskammer und die gemeinsame Öffnung in die Reaktionskammer eingeleitet, sondern entweder zusätzlich oder ausschließlich unmittelbar in die Reaktionskammer eingeleitet, also an die Stelle, an der die Borpulverreaktion stattfindet.

Bei einer weiteren Variante der Verwendung ist der Innenraum der Reaktionskammer des Reaktors mäanderförmig ausgebildet. Dadurch erhöht sich zunächst die Innenoberfläche der Reaktionskammer. Die erhöhte Innenoberfläche der Reaktionskammer erlaubt die Bereitstellung einer vergrößerten Katalysatoroberfläche in der Reaktionskammer, insbesondere an den Innenwänden der Reaktionskammer. Eine größere Katalysatoroberfläche kann wiederum für eine gesteigerte (effizientere) Borpulvergewinnung genutzt werden. Ebenso kann der Katalysator eine Strukturierung zur Vergrößerung seiner Oberfläche aufweisen.

Eine andere Variante der vorgenannten Verwendungen sieht vor, dass die Reaktionskammer einen über einen Partikelfilter geführten Auslass aufweist. Somit ist in einfacher Weise eine Aussonderung des festen Borpulvers von den restlichen gasförmigen Reaktionsprodukten möglich. Der Partikelfilter kann dabei auch mehrstufig ausgebildet sein. Das über den kontinuierlichen oder quasikontinuierlichen Gasstrom ausgeförderte Borpulver sammelt sich im Partikelfilter an und kann gelegentlich entnommen werden. Die Entnahme des Borpulvers aus dem Partikelfilter kann z.B. durch manuelles Abklopfen des Partikelfilters erfolgen. Alternativ oder zusätzlich zum Partikelfilter ist auch die Ausbildung eines Sumpfes (Reservoir) im unteren Bereich der Reaktionskammer möglich. Die Borpulveransammlung in einem solchen Sumpf ist eine einfache konstruktive Lösung um das Borpulver vom Gasstrom zu trennen. Sie basiert darauf, dass das durch die Druckgaswelle oder die Vibration abgelöste Borpulver schwerkraftbedingt in den Sumpf herabfällt. Dabei ist es zweckmäßig, den Gasstrom in horizontaler Richtung zu führen, sodass die abgelösten Borpulverkörner in vertikaler Richtung ausfallen können und sich somit vom Gasstrom trennen. Das im Sumpf angereicherte Borpulver kann dann z.B. manuell entnommen werden.

Bevorzugt ist schließlich eine Supraleiterstruktur enthaltend MgB₂, wobei das MgB₂ hergestellt ist aus einer Reaktion von Magnesium und Bor, wobei das Bor hergestellt ist nach dem erfindungsgemäßen Verfahren. Eine derartige Supraleiterstruktur besitzt eine hohe Reinheit und weist ein feinstrukturiertes Gefüge zur Erzielung einer hohen Stromtragfähigkeit auf.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Zeichnung und detaillierte Beschreibung der Erfindung

Die Erfindung ist in den Zeichnungen dargestellt und wird anhand von Ausführungsbeispielen näher erläutert. Es zeigt:
- Fig. 1: eine schematische Darstellung eines Reaktors mit an den Innenwänden einer Reaktionskammer angeordneten Katalysatoren zur Durchführung des erfindungsgemäßen Verfahrens;
- Fig. 2: eine schematische Darstellung eines Reaktors mit im Innenraum einer Reaktionskammer angeordneten Katalysatoren zur Durchführung des erfindungsgemäßen Verfahrens;
- Fig. 3: eine schematische Darstellung eines Reaktors mit einer Pulsationskammer und einer Reaktionskammer zur Durchführung des erfindungsgemäßen Verfahrens; und
- Fig. 4: eine schematische Darstellung eines Reaktors ähnlich dem Reaktor von Fig. 3, mit einem zusätzlichen Resonanzrohr an einer Pulsationskammer.

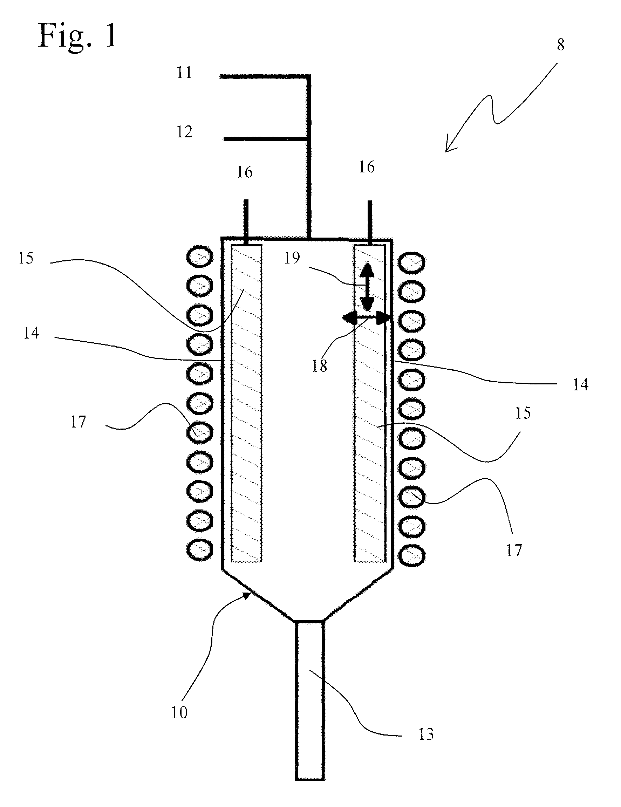

Die **Figur 1** zeigt einen schematisierten Querschnitt durch einen Reaktor 8 mit einer Reaktionskammer 10, wobei der Reaktor 8 eine erste Zuleitung 11 für ein reduzierendes Gas und eine zweite Zuleitung 12 für ein gasförmiges Borhalogenid sowie einen Auslass 13 aufweist. Die erste Zuleitung 11 und die zweite Zuleitung 12 sind dabei vor der Reaktionskammer 10 zusammen geführt und münden anschließend in die Reaktionskammer 10. Es ist jedoch auch möglich, die Zuleitungen 11, 12 voneinander getrennt in die Reaktionskammer 10 zu führen. An einer Innenwand 14 der Reaktionskammer 10 sind Katalysatoren 15 angeordnet, die über Aktuatoren 16 bewegt werden können. Die Aktuatoren 16 sind von außerhalb der Reaktionskammer 10 zugänglich. An der Innenwand 14 sind Heizelemente 17 angeordnet, wodurch die Innenwand 14 beheizbar ist.

Zur Borgewinnung wird über die erste Zuleitung 11 das reduzierende Gas, z.B. Wasserstoffgas, und über die zweite Zuleitung 12 das gasförmige Borhalogenid, z.B. Bortrichlorid, in die Reaktionskammer 10 eingedüst. Es findet eine chemische Reaktion statt, bei der an den Oberflächen der Katalysatoren 15, die z.B. aus Tantal oder Wolfram bestehen können, festes Bor angereichert wird und zusätzlich das entsprechende gasförmige Reaktionsprodukt (z.B. Halogenwasserstoff) entsteht. Durch eine beispielsweise rüttelnde Bewegung der Aktuatoren 16 wird das angereicherte Bor von den Katalysatoren 15 bzw. deren Katalysatoroberflächen abgelöst. Das abgelöste Bor, wie auch der entstehende Halogenwasserstoff, können über den Auslass 13 entweichen und anschließend voneinander getrennt werden.

Die Katalysatoren 15 können aus einfachen stabförmigen oder plattenförmigen Elementen, oder mit oberflächenvergrößernden Strukturierungen aufgebaut sein. Die Aktuatoren 16 sind in der Lage, die Katalysatoren 15 in eine regelmäßige, rüttelnde, z.B. schwingende Bewegung zu versetzen. Insbesondere umfasst die Bewegung Komponenten in einer ersten, in der Regel horizontalen Richtung 18 und einer zweiten, typischerweise hierzu senkrechten Richtung 19. Über die Heizelemente 17 kann eine gewünschte Temperatur in der Reaktionskammer 10 eingestellt werden, wobei die Heizelemente 17 z.B. Leitungen für flüssige oder gasförmige Heizmedien oder auch elektrische Heizleiter darstellen können.

Ein typisches, erfindungsgemäßes Rüttelprogramm sieht abwechselnd jeweils Wartephasen (ohne Aktuatoraktivität) und Rüttelphasen (mit Aktuatoraktivität) vor, wobei die Wartephasen wesentlich länger als die Rüttelphasen sind. Während der Wartephase wachsen Borpartikel an der Katalysatoroberfläche an, während sie in der Rüttelphase abgelöst werden, sodass danach neue Partikel zu wachsen beginnen können. Die Zufuhr der Edukte läuft während der wechselnden Warte- und Rüttelphasen kontinuierlich weiter.

Alternativ zum unmittelbaren Rütteln der Katalysatoren 15 kann auch die gesamte Reaktorkammer 10 einschließlich der dann typischerweise starr an der Innenwand 14 befestigten Katalysatoren 15 gerüttelt werden (nicht dargestellt).

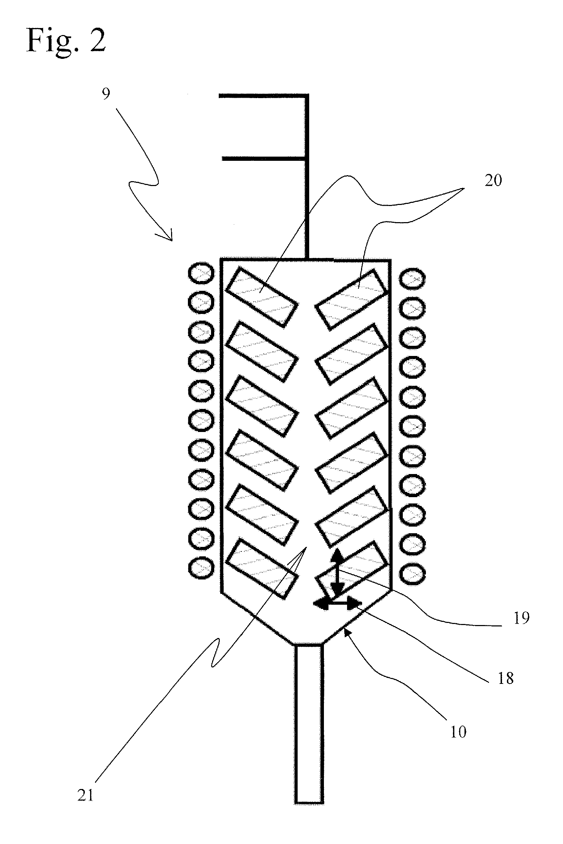

Die **Figur 2** zeigt einen Reaktor 9, der wie der Reaktor aus der Figur 1 ausgebildet ist, wobei jedoch im Unterschied hierzu Katalysatoren 20 in einem Innenraum 21 der Reaktionskammer 10 angeordnet sind. Diese Katalysatoren 20 sind über in der Figur 2 nicht dargestellte Aktuatoren mechanisch bewegbar (analog in der ersten Richtung 18 und der zweiten Richtung 19) und können selbst, z.B. elektrisch, beheizt werden.

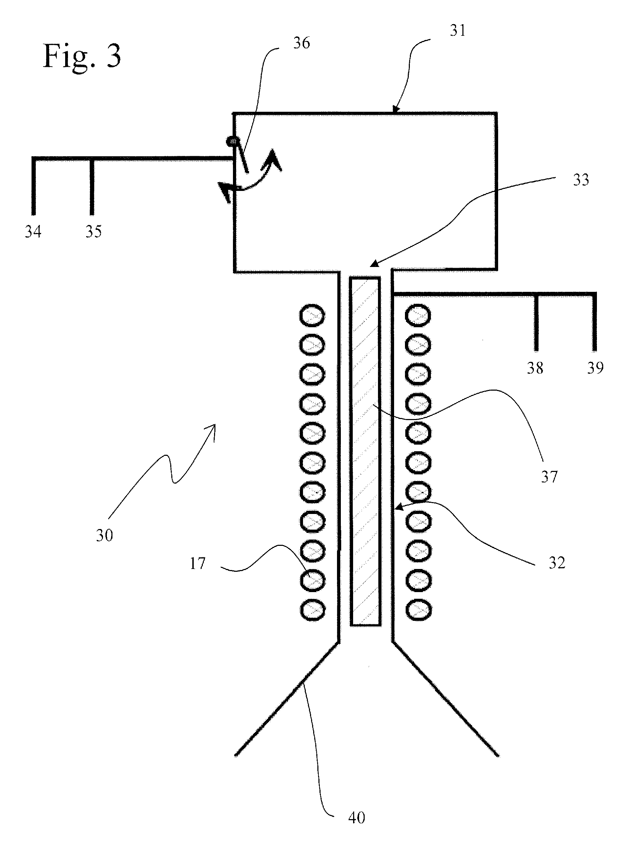

Die **Figur 3** zeigt einen schematisierten Querschnitt durch einen Reaktor 30 mit einer Pulsationskammer 31 und einer Reaktionskammer 32. Die Innenräume der Pulsationskammer 31 und der Reaktionskammer 32 sind über eine gemeinsame Öffnung 33 miteinander verbunden. Der Reaktor 30 umfasst eine erste Einleitung 34 für ein Brenngas und eine zweite Einleitung 35 für ein Oxidationsgas. Beide Einleitungen 34,35 sind außerhalb der Pulsationskammer 31 zusammengeführt und münden dann gemeinsam in die Pulsationskammer 31. Alternativ können die Einleitungen 34,35 jedoch auch einzeln in die Pulsationskammer 31 geführt sein. An der Einmündung der zusammengeführten Einleitungen in die Pulsationskammer 31 ist eine Klappe 36 vorgesehen, die die Einleitung des Brenn- und Oxidationsgases kurzzeitig unterbrechen kann (Im Falle einzeln geführter Einleitungen ist an jeder Einmündung eine solche Klappe vorgesehen). Der Querschnitt der Reaktionskammer 32 ist im Vergleich zur Pulsationskammer 31 kleiner, und im Innenraum der Reaktionskammer 32 ist ein Katalysator 37 fest angeordnet. An der Wand der Reaktionskammer 32 sind Heizelemente 17 zur Kontrolle der Temperatur in der Reaktionskammer 32 angeordnet. Im Bereich der gemeinsamen Öffnung 33 weist die Reaktionskammer 32 darüber hinaus eine dritte Einleitung 38 für das reduzierendes Gas und eine vierte Einleitung 39 für das Borhalogenid auf. Beide Einleitungen 38,39 sind außerhalb der Reaktionskammer 32 zusammengeführt und münden dann gemeinsam in die Reaktionskammer 32. Alternativ können die Einleitungen 38,39 jedoch auch getrennt voneinander in die Reaktionskammer 32 geführt sein. Am in der Figur 3 unteren Ende der Reaktionskammer 32 ist ein Auslass 40 für den Ausstoß der beteiligten Stoffe ausgebildet.

Zur Gewinnung von Borpulver werden in der Figur 3 beide Kammern 31,32 von einem Gasstrom räumlich und zeitlich nacheinander durchströmt und sind auf die gewünschte Reaktionstemperatur beheizt. Über die erste und zweite Einleitung 34, 35 werden z.B. Wasserstoffgas und Sauerstoff eingeleitet. Das explosive Gemisch aus Wasserstoffgas und Sauerstoff wird z.B. durch einen elektrisch erzeugten Zündfunken oder z. B. im Falle von Wasserstoff und Chlorgas auch über UV-Licht gezündet. Es entsteht eine Druckwelle, die kurzzeitig die Klappe 36 verschließt und somit eine weitere Zufuhr von explosivem Gemisch verhindert. Die Druckwelle entlädt sich über die gemeinsame Öffnung 33, die Reaktionskammer 32 und den Auslass 40. Der der Druckwelle folgende Sog öffnet die Klappen 36, sodass die Brenn- und Oxidationsgase erneut einströmen und zünden können. Es entsteht der Zustand einer quasikontinuierlichen, pulsierenden Verbrennung. Das Borhalogenid und das reduzierende Gas werden über die dritte und vierte Einleitung 38, 39 eingedüst, sodass am Katalysator 37 die gewünschte Reduktion zu Bor erfolgt. Die regelmäßige mechanische Ablösung des festen Bors vom Katalysator 37 geschieht über die pulsierend durch die Reaktionskammer 32 fortschreitende Druckwelle. Dieser strömungsmechanische Vorgang trägt das feste Bor von der Katalysatoroberfläche ab.

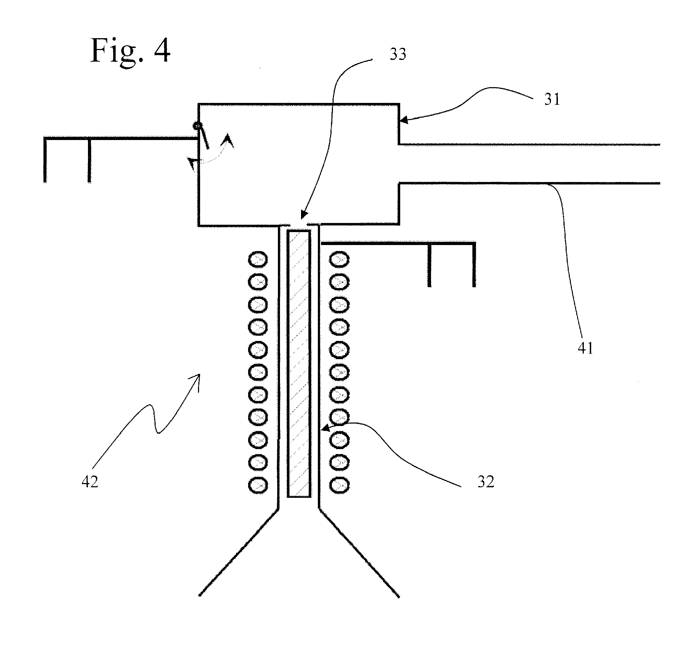

Die **Figur 4** zeigt einen schematischen Querschnitt durch einen Reaktor 42, der wie der Reaktor aus der Figur 3 ausgebildet ist, jedoch im Unterschied hierzu ein zusätzlich an die Pulsationskammer 31 angeschlossenes Resonanzrohr 41 aufweist. Über das Resonanzrohr 41 ist eine Druckentlastung in der Pulsationskammer 31 möglich, sodass die durch die Reaktionskammer 32 schreitende Druckwelle abgeschwächt wird. Darüber hinaus weist die gemeinsame Öffnung 33 eine Querschnittsverengung auf, die ebenfalls eine Abschwächung der Druckwelle in der Reaktionskammer 32 bewirken kann. Darüber hinaus minimiert die Querschnittsverengung ein Verschleppen von Oxidationsgas in die Reaktionskammer 32.

Zusammenfassend betrifft die Erfindung ein Verfahren zur Herstellung von hochreinem, amorphen Bor, wobei ein reduzierendes Gas und ein gasförmiges Borhalogenid in eine Reaktionskammer 10,32 eines Reaktors 8,9,30,42 während dessen Betriebs kontinuierlich oder quasikontinuierlich eingeleitet wird, wobei in der Reaktionskammer 10,32 des Reaktors 8,9,30,42 eine Oberfläche eines Katalysators 15,20,37 zur Verfügung gestellt wird, der die Reaktion des Borhalogenids zu Bor unterstützt, und wobei an der Oberfläche des Katalysators 15,20,37 abgeschiedenes Bor regelmäßig mechanisch abgelöst wird, so dass das abgelöste Bor in Pulverform in der Reaktionskammer 10,32 des Reaktors 8,9,30,42 vorliegt. Mit dem erfindungsgemäßen Verfahren wird hochreines amorphes Bor hergestellt, das ohne eine nachgeschaltete Zerkleinerung des gewonnenen Bors bereits eine sehr geringe Korngröße aufweist. Die Nutzung derartig hergestellten Borpulvers wird insbesondere für die Supraleiterherstellung im System Magnesium-Bor aufgrund der verbesserten Stromtragfähigkeit vorgeschlagen.

## Patentansprüche

1. Verfahren zur Herstellung von hochreinem, amorphen Bor,
wobei ein reduzierendes Gas und ein gasförmiges Borhalogenid in eine Reaktionskammer (10;32) eines Reaktors (8;9;30;42) während dessen Betriebs kontinuierlich oder quasikontinuierlich eingeleitet wird,
**dadurch gekennzeichnet, dass**
a) in der Reaktionskammer (10;32) des Reaktors (8;9;30;42) eine Oberfläche eines Katalysators (15;20;37) zur Verfügung gestellt wird, der die Reaktion des Borhalogenids zu Bor unterstützt,
b) und an der Oberfläche des Katalysators (15;20;37) abgeschiedenes Bor regelmäßig mechanisch abgelöst wird, so dass das abgelöste Bor in Pulverform in der Reaktionskammer (10;32) des Reaktors (8;9;30;42) vorliegt.

2. Verfahren nach Anspruch 1, **dadurch gekennzeichnet, dass** die mechanische Ablösung des abgeschiedenen Bors während des Betriebs des Reaktors (8;9;30;42) erfolgt.

3. Verfahren nach einem der vorhergehenden Ansprüche, **dadurch gekennzeichnet, dass** zur mechanischen Ablösung des abgeschiedenen Bors von der Oberfläche des Katalysators (15;20;37) der Katalysator (15;20;37) in Schwingung versetzt wird.

4. Verfahren nach einem der vorhergehenden Ansprüche, **dadurch gekennzeichnet, dass** zur mechanischen Ablösung des abgeschiedenen Bors von der Oberfläche des Katalysators (15;20;37) eine Druckgaswelle über die Oberfläche des Katalysators (15;20;37) geleitet wird.

5. Verfahren nach einem der vorhergehenden Ansprüche, **dadurch gekennzeichnet, dass** zur mechanischen Ablösung des abgeschiedenen Bors von der Oberfläche des Katalysators (15;20;37) die Oberfläche des Katalysators (15;20;37) abgestreift wird.

6. Verfahren nach einem der vorhergehenden Ansprüche, **dadurch gekennzeichnet, dass** als reduzierendes Gas Wasserstoffgas eingesetzt wird.

7. Verfahren nach einem der vorhergehenden Ansprüche, **dadurch gekennzeichnet, dass** als Borhalogenid BCl₃ oder BBr₃ eingesetzt wird.

8. Verfahren nach einem der vorhergehenden Ansprüche, **dadurch gekennzeichnet, dass** der Katalysator (15;20;37) Wolfram und/oder Tantal enthält.

9. Verfahren nach einem der vorhergehenden Ansprüche, **dadurch gekennzeichnet, dass** die Reaktion zwischen dem reduzierenden Gas und dem Borhalogenid bei einer Temperatur zwischen 700°C und 1100°C, und bevorzugt zwischen 800°C und 1000°C, geführt wird.

10. Verwendung eines Reaktors (8;9;30;42) in einem Verfahren zur Herstellung von hochreinem, amorphen Bor gemäß einem der Ansprüche 1 bis 9,
wobei der Katalysator (15;20;37) an mindestens einer Innenwand (14) der Reaktionskammer (10;32) des Reaktors (8;9;30;42) angeordnet ist, und wobei zur mechanischen Ablösung des abgeschiedenen Bors von der Oberfläche des Katalysators (15;20;37) ein mechanischer Aktuator (16) vorgesehen ist, mit dem die Reaktionskammer (10;32) des Reaktors (8;9;30;42) in Schwingung versetzt werden kann.

11. Verwendung eines Reaktors (8;9;30;42) in einem Verfahren zur Herstellung von hochreinem, amorphen Bor gemäß einem der Ansprüche 1 bis 9,
wobei der Katalysator (15;20;37) im Innenraum der Reaktionskammer (10;32) des Reaktors (8;9;30;42) angeordnet ist,
und wobei zur mechanischen Ablösung des abgeschiedenen Bors von der Oberfläche des Katalysators (15;20;37) ein mechanischer Aktuator vorgesehen ist, mit dem der Katalysator (15;20;37) im Innenraum der Reaktionskammer (10;32) des Reaktors (8;9;30;42) in Schwingung versetzt werden kann.

12. Verwendung eines Reaktors (8;9;30;42) in einem Verfahren zur Herstellung von hochreinem, amorphen Bor gemäß einem der Ansprüche 1 bis 9,
wobei der Reaktor (8;9;30;42) eine Pulsationskammer (31) und die Reaktionskammer (10;32) aufweist,
wobei die Pulsationskammer (31) und die Reaktionskammer (10;32) über eine gemeinsame Öffnung (33) miteinander verbunden sind,
wobei der Strömungsquerschnitt der Pulsationskammer (31) größer ist als der Strömungsquerschnitt der Reaktionskammer (10;32),
wobei die Pulsationskammer (31) über ein Klappensystem mit einem Brenngas und einem Oxidationsgas befüllt wird,
wobei das Brenngas und das Oxidationsgas in der Pulsationskammer (31) ein explosives Gasgemisch bilden, das regelmäßig zur Explosion gebracht wird,
und wobei sich das Klappensystem automatisch bei einem von der Explosion herrührenden Druckanstieg in der Pulsationskammer (31) schließt.

13. Verwendung nach Anspruch 12, **dadurch gekennzeichnet, dass** die Pulsationskammer (31) einen Ablass, insbesondere ein Resonanzrohr (41), zur Entlastung des Explosionsdrucks aufweist.

14. Verwendung nach einem der Ansprüche 12 oder 13, **dadurch gekennzeichnet, dass** in der Pulsationskammer (31) als Brenngas im explosiven Gasgemisch das gleiche Gas eingesetzt wird wie in der Reaktionskammer (10;32) als reduzierendes Gas.

15. Verwendung nach einem der Ansprüche 12 bis 14, **dadurch gekennzeichnet, dass** im explosiven Gasgemisch das Brenngas im Vergleich zum Oxidationsgas im Überschuss eingesetzt wird.

16. Verwendung nach einem der Ansprüche 12 bis 15, **dadurch gekennzeichnet, dass** das Borhalogenid direkt, insbesondere kontinuierlich, in die Reaktionskammer (10;32) eingeleitet wird.

17. Verwendung nach einem der Ansprüche 12 bis 16, **dadurch gekennzeichnet, dass** das reduzierende Gas direkt, insbesondere kontinuierlich, in die Reaktionskammer (10;32) eingeleitet wird.

18. Verwendung nach einem der Ansprüche 10 bis 17, **dadurch gekennzeichnet, dass** der Innenraum der Reaktionskammer (10;32) des Reaktors (8;9;30;42) mäanderförmig ausgebildet ist.

19. Verwendung nach einem der Ansprüche 10 bis 18, **dadurch gekennzeichnet, dass** die Reaktionskammer (10;32) einen über einen Partikelfilter geführten Auslass (13;40) aufweist.

20. Supraleiterstruktur enthaltend MgB₂, wobei das MgB₂ hergestellt ist aus einer Reaktion von Magnesium und Bor, wobei das Bor hergestellt ist mit einem Verfahren nach einem der Ansprüche 1 bis 9.
